# EUROPEAN PATENT SPECIFICATION

(11) **EP 3 180 802 B1**
(45) Date of publication and mention of the grant of the patent: **06.05.2020**
(21) Application number: 15829048.6
(22) Date of filing: 23.07.2015
(51) Int. Cl.: H01L 21/762, H01L 21/8238, H01L 23/485, B81C 1/00

(54) **SEMICONDUCTOR STRUCTURE WITH MULTIPLE ACTIVE LAYERS IN AN SOI WAFER**
HALBLEITERSTRUKTUR MIT MEHREREN AKTIVEN SCHICHTEN IN EINEM SOI-WAFER
STRUCTURE SEMI-CONDUCTRICE À MULTIPLES COUCHES ACTIVES DANS UNE TRANCHE DE SILICIUM SUR ISOLANT (SOI)

(30) Priority: 07.08.2014 US 201414454262
(43) Date of publication of application: 21.06.2017
(73) Proprietor: QUALCOMM Incorporated, San Diego, CA 92121-1714 (US)
(72) Inventor: FANELLI, Stephen A., San Diego, California 92121 (US)
(74) Representative: Dunlop, Hugh Christopher
(86) International application number: PCT/US2015/041769
(87) International publication number: WO 2016/022302

(56) References cited:
- US-A1- 2008 179 678
- US-A1- 2009 134 459
- US-A1- 2015 179 505
- US-B1- 6 297 090
- US-B1- 8 334 729
- US-B2- 8 368 143
- US-B2- 8 466 036

## Description

### Background of the Invention

Integrated circuits (ICs) vertical integration techniques utilize multiple active/device layers on a single die. These techniques allows for a significant increase in the number of components per IC without increasing the required die area. The die thickness may be increased, but it is the die area that is usually more of a limiting design consideration, and the overall result can be a reduced total die volume and IC package weight. The development of vertical integration techniques is, thus, of paramount importance for technologies in which electronic devices must be relatively small and lightweight, e.g. cell/smart phones, notebook/tablet PCs, etc.

US 2008/0179678 A1 relates to semiconductor structures having semiconductor devices on both sides of a semiconductor-on-insulator substrate.

US 8466036 B2 relates to an integrated circuit chip with an active layer and a trap rich layer formed above the active layer. US 8334729 B1 relates to impedance matching circuits based on micro-electromechanical mechanical system structures. US 2009/0134459 A1 relates to simplifying packaging structure of an semiconductor device including a MEMS sensor and an LSI circuit. This document describes a method and a structure according to the preamble of claims 1 and 8.

### Summary

A method according to the invention and the structure resulting from this method are defined in the claims 1 and 8.

### Brief Description of the Drawings

Fig. 1 is a simplified cross-section of a semiconductor structure incorporating an example of the present invention.
Figs. 2-5 are simplified cross-sections of semiconductor structures at intermediate stages in the fabrication of the semiconductor structure shown in Fig. 1 in accordance with examples of the present invention.
Fig. 6 is a simplified cross-section of an alternative semiconductor structure incorporating an example of the present invention.

### Detailed Description of the Invention

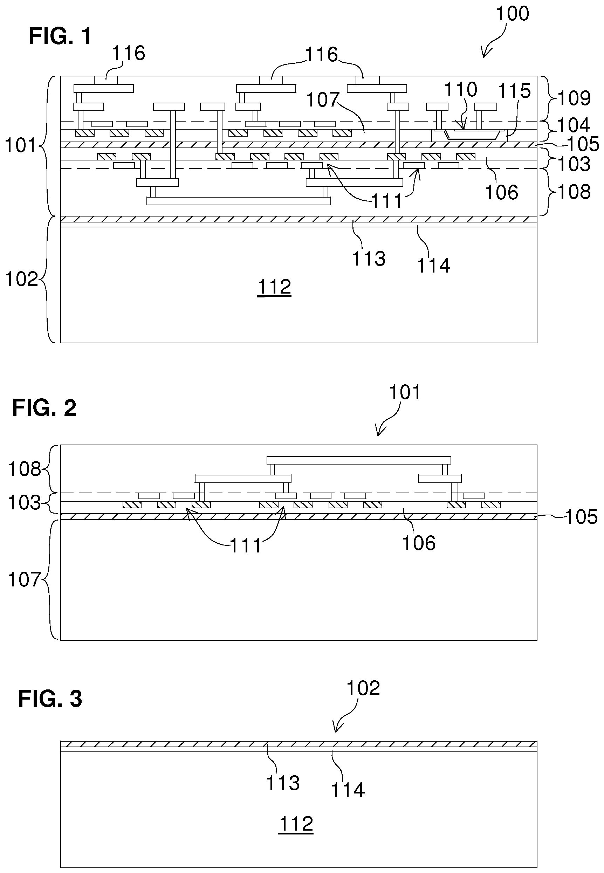

According to some embodiments, the present invention achieves vertical integration of active layers in a monolithically formed IC semiconductor structure (e.g. semiconductor structure 100 of Fig. 1) using a semiconductor-on-insulator (SOI) wafer. In general, after a first active layer is formed in and on the SOI wafer, the SOI wafer is inverted, and a second active layer is formed in and on the underlying substrate, as described in more detail below. This technique generally enables a relatively compact vertical integration of a variety of types of active layers with a significant reduction of die area and an increase in die per wafer. Additionally, in some embodiments, the multiple active layers may enable the integration of CMOS devices in the same monolithic semiconductor structure with other types of devices, such as film bulk acoustic resonators, surface acoustic wave devices, film plate acoustic resonators (FPAR), acoustic filters, RF switches, passive components, and other microelectromechanical systems (MEMS) devices.

In the example shown in Fig. 1, the semiconductor structure 100 generally has an inverted SOI wafer 101 bonded with a handle wafer 102. The SOI wafer 101 generally has two active layers 103 and 104 on both opposite sides (i.e. top/bottom or upper/lower) of an insulator layer 105 (e.g. a buried oxide). The first active layer 103 is formed in and on the conventional semiconductor layer 106 of the SOI wafer 101. The second active layer 104 is formed in and on the underlying conventional substrate layer 107 of the SOI wafer 101, or the portion that remains after thinning the original substrate layer 107. The components that are shown within the active layers 103 and 104 are provided for illustrative purposes only and do not necessarily depict limitations on the present invention.

Additionally, the SOI wafer 101 generally includes interconnect layers 108 and 109, through which electrical connections may be made between the various components of the active layers 103 and 104. The components that are shown within the interconnect layers 108 and 109 are provided for illustrative purposes only and do not necessarily depict limitations on the present invention. In some embodiments, for example, one of the active layers (e.g. 104) may include an RF/MEMS device 110 (among other components), and the other active layer (e.g. 103) may include CMOS devices 111 (among other components) for circuitry that controls operation of the MEMS device 110.

The handle wafer 102 generally includes a handle substrate layer 112, a bonding layer 113, and an optional trap rich layer (TRL) 114. The handle wafer 102 is bonded to a top surface of the SOI wafer 101 (inverted as shown) after the formation of the first active layer 103 and the first interconnect layer 108. The handle wafer 102 is generally used to provide structural stability for the semiconductor structure 100 while processing the substrate layer 107 of the SOI wafer 101 and the formation of the second active layer 104 and second interconnect layer 109. In some embodiments, the structural stability aspect enables the substrate layer 107 of the SOI wafer 101 to be thinned before formation of the second active layer 104.

The first and second active layers 103 and 104 and the first and second interconnect layers 108 and 109 are described herein as being built up both into and onto the semiconductor layer 106 and substrate layer 107, respectively. This type of fabrication technique is known as a "monolithic" style of fabrication. A different technique of active layer fabrication is known as a "layer transfer" style, which involves the formation of the active layers in and on multiple separate wafers, followed by transferring one of the active layers onto the wafer of the other. There are various advantages and disadvantages for both of these techniques. The monolithic style, for example, generally requires serial processing for each of the manufacturing steps; whereas, the layer transfer style allows for parallel processing of the multiple wafers, thereby potentially reducing the overall time to manufacture the final semiconductor structure. However, the monolithic style generally does not require the expense of multiple substrates, does not require wafer bonding or wafer cleavage steps, does not require significant grinding or etching back steps, does not require precision wafer-aligning for bonding, and does not require a capital investment for fabrication machines that can perform the wafer-bonding-related steps. Some general exceptions to these advantages may occur in some situations, such as the wafer bonding of the handle wafer 102. However, since the handle wafer 102 does not have additional circuitry prior to bonding, there is no need for a high-precision alignment of the wafers 101 and 102. Thus, the bonding step for the handle wafer 102 can be relatively simple and cheap compared to approaches where multiple active layers on multiple wafers are integrated via a layer transfer process.

A simplified example manufacturing process, according to some embodiments for forming the semiconductor structure 100 of Fig. 1, is shown by Figs. 2-5. The process generally starts with the SOI wafer 101 having the insulator layer 105 (e.g. a buried oxide) between the semiconductor layer 106 and substrate layer 107 as shown in Fig. 2. The first active layer 103 is then formed into and onto the "top" or "upper" surface of the semiconductor layer 106 using mostly conventional process steps. In situations where the active devices in active layer 103 are CMOS transistors, these process steps are those typically associated with single wafer monolithic CMOS manufacturing.

The first interconnect layer 108 is then formed on the "top" or "upper" surface of the first active layer 103. Since the SOI wafer 101 is subsequently inverted from the orientation shown in Fig. 2, for the benefit of consistency in description, the portion of the SOI wafer 101 referred to as the "top" (or "upper" or "front") with respect to Fig. 2 will continue to be referred to herein as the "top" (or "upper" or "front"), and the portion of the SOI wafer 101 referred to as the "bottom" (or "lower" or "back") will continue to be referred to herein as the "bottom" (or "lower" or "back"), even after the SOI wafer 101 has been inverted. Therefore, in Fig. 1, the "top" of the overall semiconductor structure 100 is considered the same as the "bottom" of the SOI wafer 101. Also, when the top of the overall semiconductor structure 100 is being processed, it is considered "back side" processing for the SOI wafer 101.

Additionally, for purposes of description herein, when material or layers are added to a wafer, the added material or layers are considered to become part of the wafer. Also, when material or layers are removed from the wafer, the removed material or layers are no longer considered to be part of the wafer. Therefore, for example, the element designated as the SOI wafer 101 or the handle wafer 102 in the Figs. may increase or decrease in size or thickness as it is being processed.

Also, for purposes of description herein, a surface referred to as the "top surface" or "bottom surface" of a wafer may change during processing when material or layers are added to or removed from the wafer. For example, the first active layer 103 is formed by front side processing in and on the top surface of the SOI wafer 101, but the material that is placed on the SOI wafer 101 creates a new top surface. Thus, the first interconnect layer 108 is formed on the new top surface. Then when the handle wafer 102 is bonded to the SOI wafer 101, it is bonded to yet another new top surface thereof.

Furthermore, various layers of materials are described herein. However, there is not necessarily a distinct demarcation line between some of the layers. For example, some materials formed during fabrication of the interconnect layers 108 or 109 may extend into other layers. Through semiconductor vias (TSVs), for example, may be formed through the active layers 103 or 104 and the insulator layer 105. Other examples of overlapping layers may also become apparent.

The simplified example manufacturing process, according to some embodiments for forming the semiconductor structure 100 of Fig. 1, continues with the formation of the handle wafer 102 as shown in Fig. 3. The bonding layer 113, and the TRL 114 are formed on the handle substrate layer 112. The handle substrate layer 112 is generally thick enough to provide structural stability or strength to the semiconductor structure 100. The TRL 114 is formed by any appropriate technique, e.g. implanting ions of high energy particles (e.g. a noble gas, Silicon, Oxygen, Carbon, Germanium, etc.), irradiating the handle wafer 102, depositing high resistivity material, damaging the exposed surfaces of the handle substrate layer 112, etc. The bonding layer 113 may be any appropriate material that can be bonded to the material at the top surface of the SOI wafer 101. Other bonding techniques for other embodiments with or without the bonding layer 113 may also be used. In some embodiments, the bonding layer 113 may be combined with the TRL 114. In some embodiments, the entire handle wafer 102 will be the TRL 114.

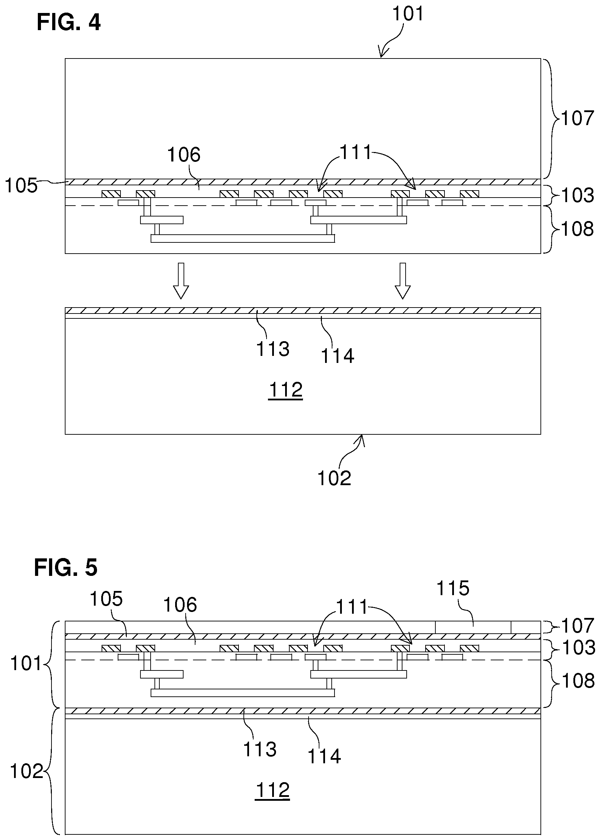

As shown in Fig. 4, SOI wafer 101 of Fig. 2 is bonded to the handle wafer 102 of Fig. 3. The SOI wafer 101 is inverted in Fig. 4 relative to its orientation in Fig. 2. The surface of the SOI wafer 101 to which the handle wafer 102 is bonded is the top surface, which is opposite the insulator layer from the substrate layer 107. This step leaves the bottom or back side of the SOI wafer 101 exposed for processing. The handle wafer 102 provides structural stability during this processing.

A portion of the substrate layer 107 is removed, thereby thinning the substrate layer 107, as shown in Fig. 5. The remaining portion of the substrate layer 107 is sufficiently thick to be used as a new semiconductor layer for the formation of a second active layer, such as the second active layer 104 in Fig. 1.

In some embodiments, since the MEMS device 110 is to be formed in the second active layer 104, a cavity 115 may be formed in the substrate layer 107. The cavity 115 at least partly surrounds the MEMS device 110. The cavity 115 may be formed by any appropriate technique, e.g. orientation dependent etch, anisotropic etch, isotropic etch, etc. The cavity 115 provides isolation, improved thermal performance and/or a material for release of the MEMS device 110. A fill material is then placed inside the cavity 115 and planarized, e.g. by CMP. The fill material may be selective to the material that forms second active layer 104, so the fill material can be removed later to release the MEMS device 110. In some embodiments, the cavity 115 may extend into the insulator layer 105, so the fill material may have to be selective to the insulator material.

The second active layer 104 is then formed in and on the remaining portion of the substrate layer 107. In some embodiments, fabrication of the MEMS device 110 within the second active layer 104 is done in reverse order from the conventional process. This reverse process may aid in simplifying the bonding and interconnection for low temperatures (e.g. less than 200°C).

The second interconnect layer 109 is then formed on the second active layer 104 (and through the two active layers 103 and 104) to produce the semiconductor structure 100 shown in Fig. 1. In some embodiments, some of the electrical connections between the two active layers 103 and 104 may be formed with a buried contact, e.g. forming TSVs early in the overall fabrication process. Electrical connection pads 116 and a redistribution layer (not shown) may also be formed for external electrical connections. Electrical interconnects, e.g. TSVs, that pass through more than one layer may provide electrical connections between any two or more components in the two interconnect layers 108 and 109 and the active layers 103 and 104, e.g. a TSV interconnect between metallization in the interconnect layers 108 and 109, or a TSV interconnect between metallization in one of the interconnect layers 108 or 109 and an active device (e.g. source, drain or gate region) in one of the active layers 108 or 109.

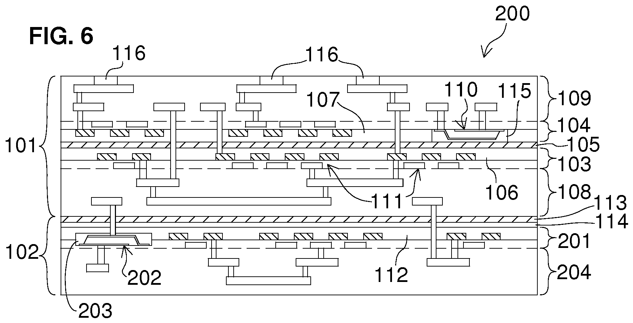

An alternative semiconductor structure 200 incorporating an alternative embodiment of the present invention is shown in Fig. 6. In this case, many of the elements are similar to those of the embodiment shown in Fig. 1, because this embodiment may be built up from the semiconductor structure 100. However, a portion of the handle substrate layer 112 is removed, thereby thinning the handle substrate layer 112. The remaining portion of the handle substrate layer 112 is sufficiently thick to be used as a new semiconductor layer for the formation of a third active layer 201, thereby monolithically forming yet another active layer. In some embodiments, another handle wafer (not shown) may be bonded to the semiconductor structure 100 to provide structural stability during subsequent processing if the existing thickness of the semiconductor structure 100 does not provide sufficient structural stability.

In some embodiments, a MEMS device 202 is formed in the third active layer 201, such thata cavity 203 may need to be formed in the handle substrate layer 112. The cavity 203 may be formed by any appropriate technique, e.g. orientation dependent etch, anisotropic etch, isotropic etch, etc. The cavity 203 provides isolation, improved thermal performance and/or a material for release of the MEMS device 202. A fill material is then placed inside the cavity 203 and planarized, e.g. by CMP. The fill material may be selective to the material of third active layer 201, so the fill material can be removed later to release the MEMS device 202.

The third active layer 201 is then formed in and on the remaining portion of the handle substrate layer 112.

A third interconnect layer 204 is then formed on the third active layer 201 (and through to the first active layer 103) to produce the semiconductor structure 200 shown in Fig. 6. In some embodiments, some of the electrical connections between the first and third active layers 103 and 201 may be formed with a buried contact, e.g. forming TSVs early in the overall fabrication process. The third active layer 201 may also be connected to the second active layer 104 via contacts between those layers and a common circuit node in interconnect layer 108. Electrical connection pads (not shown) and a redistribution layer (not shown) may also be formed for external electrical connections on the bottom side of the alternative semiconductor structure 200. Alternatively or in combination, electrical connection pads 116 and a redistribution layer (not shown) may also be formed for external electrical connections to the bottom side of the alternative semiconductor structure 200.

## Claims

1. A method comprising:
providing a semiconductor-on-insulator, SOI, wafer (101), the SOI wafer having:
an insulator layer (105) between a substrate layer (107) and a semiconductor layer (106); and
a first side and a second side, wherein the second side is opposite to the first side;
forming a first active layer (103) in and on the semiconductor layer on the first side of the SIO wafer, wherein the first active layer comprises a plurality of CMOS devices (111);
forming a second active layer (104) in and on the substrate layer on the second side of the SOI wafer, wherein the second active layer comprises a MEMS device (110);
forming a first interconnect layer (108) on the first active layer, the first interconnect layer electrically coupling the plurality of CMOS devices of the first active layer;
**characterised by**:
forming a second interconnect layer (109) on the second active layer; and
forming electrical connections between the second interconnect layer and the first and second active layers.

2. The method of claim 1, further comprising:
removing a first portion of the substrate layer; and
forming the second active layer in and on a second portion of the substrate layer.

3. The method of claim 2, further comprising:
before the removing of the first portion of the substrate layer, bonding a handle wafer (102) to the first side of the SOI wafer; and
removing the first portion of the substrate layer from the second side of the SOI wafer.

4. The method of claim 3, further comprising:
providing a trap rich layer (114) in the handle wafer.

5. The method of claim 1, further comprising:
bonding a handle wafer (102) to a surface of the SOI wafer, the surface of the SOI wafer being opposite the insulator layer from the substrate layer, and the handle wafer having a handle substrate layer (112); and
forming a third active layer in and on the handle substrate layer.

6. The method of claim 5, further comprising:
removing a first portion of the handle substrate layer; and
forming the third active layer in and on a second portion of the handle substrate layer.

7. The method of claim 1, further comprising:
forming a cavity for the MEMS device in at least one of: the substrate layer and the insulator layer.

8. A semiconductor structure comprising:
a semiconductor-on-insulator, SOI, wafer (101), the SOI wafer having:
an insulator layer (105) between a semiconductor layer (107) and a substrate layer (106); and
a first side and a second side, wherein the second side is opposite to the first side;
a first active layer (103) formed in and on the semiconductor layer on the first side of the SOI wafer, wherein the first active layer comprises a plurality of CMOS devices (111);
a second active layer (104) formed in and on the substrate layer on the second side of the SOI wafer, wherein the second active layer comprises a MEMS device (110);
a first interconnect layer (108) formed on the first active layer, the first interconnect layer electrically coupling the plurality of CMOS devices of the first active layer;
**characterised by**: a second interconnect layer (109) formed on the second active layer; and
electrical connections formed between the second interconnect layer and the first and second active layers.

9. The semiconductor structure of claim 8, wherein:
the second active layer is formed in and on a remaining portion of the substrate layer after the substrate layer has been thinned.

10. The semiconductor structure of claim 9, further comprising:
a handle wafer bonded to a surface of the SOI wafer opposite the insulator layer from the substrate layer.

11. The semiconductor structure of claim 10, wherein:
the handle wafer has a trap rich layer.

12. The semiconductor structure of claim 8, further comprising:
a handle wafer bonded to a surface of the SOI wafer, the surface of the SOI wafer being opposite the insulator layer from the substrate layer, the handle wafer having a handle substrate layer; and
a third active layer formed in and on the handle substrate layer.

13. The semiconductor structure of claim 12, wherein:
the third active layer is formed in and on a remaining portion of the handle substrate layer after the handle substrate layer has been thinned.

## Patentansprüche

1. Ein Verfahren, das Folgendes aufweist:
Vorsehen eines Halbleiter-auf-Isolator- bzw. SOI-Wafers (SOI = semiconductor-on-insulator) (101), wobei der SOI-Wafer Folgendes hat:
eine Isolatorschicht (105) zwischen einer Substratschicht (107) und einer Halbleiterschicht (106); und
eine erste Seite und eine zweite Seite, wobei die zweite Seite zu der ersten Seite entgegengesetzt ist;
Bilden einer ersten aktiven Schicht (103) in und auf der Halbleiterschicht auf der ersten Seite des SOI-Wafers, wobei die erste aktive Schicht eine Vielzahl von CMOS-Einrichtungen (111) aufweist;
Bilden einer zweiten aktiven Schicht (104) in und auf der Substratschicht auf der zweiten Seite des SOI-Wafers, wobei die zweite aktive Schicht eine MEMS-Einrichtung (110) aufweist;
Bilden einer ersten Zwischenverbindungsschicht (108) auf der ersten aktiven Schicht, wobei die erste Zwischenverbindungsschicht elektrisch die Vielzahl von CMOS-Einrichtungen der ersten aktiven Schicht koppelt;
**gekennzeichnet durch**:
Bilden einer zweiten Zwischenverbindungsschicht (109) auf der zweiten aktiven Schicht; und
Bilden elektrischer Verbindungen zwischen der zweiten Zwischenverbindungsschicht und den ersten und zweiten aktiven Schichten.

2. Verfahren nach Anspruch 1, das weiter Folgendes aufweist:
Entfernen eines ersten Teils der Substratschicht; und
Bilden der zweiten aktiven Schicht in und auf einem zweiten Teil der Substratschicht.

3. Verfahren nach Anspruch 2, das weiter Folgendes aufweist:
vor dem Entfernen des ersten Teils der Substratschicht, Bonden bzw. Kleben eines Handhabungswafers (102) an die erste Seite des SOI-Wafers; und Entfernen des ersten Teils der Substratschicht von der zweiten Seite des SOI-Wafers.

4. Verfahren nach Anspruch 3, das weiter Folgendes aufweist:
Vorsehen einer Trap-Rich-Layer (114) in dem Handhabungswafer.

5. Verfahren nach Anspruch 1, das weiter Folgendes aufweist:
Bonden bzw. Kleben eines Handhabungswafers (102) an eine Oberfläche des SOI-Wafers, wobei die Oberfläche des SOI-Wafers zu der Isolatorschicht von der Substratschicht entgegengesetzt ist, und der Handhabungswafer eine Handhabungssubstratschicht (112) hat; und
Bilden einer dritten aktiven Schicht in und auf der Handhabungssubstratschicht.

6. Verfahren nach Anspruch 5, das weiter Folgendes aufweist:
Entfernen eines ersten Teils der Handhabungssubstratschicht; und
Bilden der dritten aktiven Schicht in und auf einem zweiten Teil der Handhabungssubstratschicht.

7. Verfahren nach Anspruch 1, das weiter Folgendes aufweist:
Bilden einer Ausnehmung für die MEMS-Einrichtung in wenigstens einem von: der Substratschicht und der Isolatorschicht.

8. Eine Halbleiterstruktur, die Folgendes aufweist:
einen Halbleiter-auf-Isolator- bzw. SOI-Wafer (SOI = semiconductor-on-insulator) (101), wobei der SOI-Wafer Folgendes hat:
eine Isolatorschicht (105) zwischen einer Substratschicht (107) und einer Halbleiterschicht (106); und
eine erste Seite und eine zweite Seite, wobei die zweite Seite zu der ersten Seite entgegengesetzt ist;
eine erste aktive Schicht (103), die in und auf der Halbleiterschicht auf der ersten Seite des SOI-Wafers ausgebildet ist, wobei die erste aktive Schicht eine Vielzahl von CMOS-Einrichtungen (111) aufweist;
eine zweite aktive Schicht (104), die in und auf der Substratschicht auf der zweiten Seite des SOI-Wafers ausgebildet ist, wobei die zweite aktive Schicht eine MEMS-Einrichtung (110) aufweist;
eine erste Zwischenverbindungsschicht (108), die auf der ersten aktiven Schicht ausgebildet ist, wobei die erste Zwischenverbindungsschicht elektrisch die Vielzahl von CMOS-Einrichtungen der ersten aktiven Schicht koppelt;
**gekennzeichnet durch**:
eine zweite Zwischenverbindungsschicht (109), die auf der zweiten aktiven Schicht ausgebildet ist; und
elektrische Verbindungen, die zwischen der zweiten Zwischenverbindungsschicht und den ersten und zweiten aktiven Schichten ausgebildet sind.

9. Halbleiterstruktur nach Anspruch 8, wobei:
die zweite aktive Schicht in und auf einem verbleibenden Teil der Substratschicht ausgebildet wird, nachdem die Substratschicht dünner gemacht worden ist.

10. Halbleiterstruktur nach Anspruch 9, die weiter Folgendes aufweist:
einen Handhabungswafer, der an eine Oberfläche des SOI-Wafers entgegengesetzt zu der Isolatorschicht von der Substratschicht gebondet bzw. geklebt ist.

11. Halbleiterstruktur nach Anspruch 10, wobei:
der Handhabungswafer eine Trap-Rich-Layer hat.

12. Halbleiterstruktur nach Anspruch 8, die weiter Folgendes aufweist:
einen Handhabungswafer, der an eine Oberfläche des SOI-Wafers gebondet bzw. geklebt ist, wobei die Oberfläche des SOI-Wafers zu der Isolatorschicht von der Substratschicht entgegengesetzt ist, wobei der Handhabungswafer eine Handhabungssubstratschicht hat; und
eine dritte aktive Schicht, die in und auf der Handhabungssubstratschicht ausgebildet ist.

13. Halbleiterstruktur nach Anspruch 12, wobei:
die dritte aktive Schicht in und auf einem verbleibenden Teil der Handhabungssubstratschicht ausgebildet wird, nachdem die Handhabungssubstratschicht dünner gemacht worden ist.

## Revendications

1. Procédé comprenant les étapes consistant à :
fournir une plaquette de semi-conducteur sur isolant, SOI (101), la plaquette de SOI comportant :
une couche d'isolant (105) entre une couche de substrat (107) et une couche semi-conductrice (106) ; et
un premier côté et un second côté, le second côté se situant à l'opposé du premier côté ;
former une première couche active (103) dans et sur la couche semi-conductrice sur le premier côté de la plaquette de SOI, la première couche active comprenant une pluralité de dispositifs CMOS (111) ;
former une deuxième couche active (104) dans et sur la couche de substrat sur le second côté de la plaquette de SOI, la deuxième couche active comprenant un dispositif MEMS (110) ;
former une première couche d'interconnexion (108) sur la première couche active, la première couche d'interconnexion couplant électriquement la pluralité de dispositifs CMOS de la première couche active ;
**caractérisé en ce qu'**il comprend des étapes consistant à :
former une seconde couche d'interconnexion (109) sur la deuxième couche active ; et
former des connexions électriques entre la seconde couche d'interconnexion et les première et seconde couches actives.

2. Procédé selon la revendication 1, comprenant en outre des étapes consistant à :
retirer une première partie de la couche de substrat ; et
former la deuxième couche active dans et sur une seconde partie de la couche de substrat.

3. Procédé selon la revendication 2, comprenant en outre des étapes consistant à :
avant le retrait de la première partie de la couche de substrat, lier une plaquette de manipulation (102) au premier côté de la plaquette de SOI ; et
retirer la première partie de la couche de substrat du second côté de la plaquette de SOI.

4. Procédé selon la revendication 3, comprenant en outre une étape consistant à :
fournir une couche riche en piège (114) dans la plaquette de manipulation.

5. Procédé selon la revendication 1, comprenant en outre des étapes consistant à :
lier une plaquette de manipulation (102) à une surface de la plaquette de SOI, la surface de la plaquette de SOI étant à l'opposé de la couche d'isolant par rapport à la couche de substrat, et la plaquette de manipulation ayant une couche de substrat de manipulation (112) ; et
former une troisième couche active dans et sur la couche de substrat de manipulation.

6. Procédé selon la revendication 5, comprenant en outre des étapes consistant à :
retirer une première partie de la couche de substrat de manipulation ; et
former la troisième couche active dans et sur une seconde partie de la couche de substrat de manipulation.

7. Procédé selon la revendication 1, comprenant en outre une étape consistant à :
former une cavité pour le dispositif MEMS dans au moins l'une de : la couche de substrat et la couche d'isolant.

8. Structure semi-conductrice comprenant :
une plaquette de semi-conducteur sur isolant, SOI (101), la plaquette de SOI comportant :
une couche d'isolant (105) entre une couche semi-conductrice (107) et une couche de substrat (106) ; et
un premier côté et un second côté, le second côté se situant à l'opposé du premier côté ;
une première couche active (103) formée dans et sur la couche semi-conductrice sur le premier côté de la plaquette de SOI, la première couche active comprenant une pluralité de dispositifs CMOS (111) ;
une deuxième couche active (104) formée dans et sur la couche de substrat sur le second côté de la plaquette de SOI, la deuxième couche active comprenant un dispositif MEMS (110) ;
une première couche d'interconnexion (108) formée sur la première couche active, la première couche d'interconnexion couplant électriquement la pluralité de dispositifs CMOS de la première couche active ;
**caractérisée par** : une seconde couche d'interconnexion (109) formée sur la deuxième couche active ; et
des connexions électriques formées entre la seconde couche d'interconnexion et les première et seconde couches actives.

9. Structure semi-conductrice selon la revendication 8 :
la seconde couche active étant formée dans et sur une partie restante de la couche de substrat après que la couche de substrat a été amincie.

10. Structure semi-conductrice selon la revendication 9, comprenant en outre :
une plaquette de manipulation liée à une surface de la plaquette de SOI à l'opposé de la couche isolante par rapport à la couche de substrat.

11. Structure semi-conductrice selon la revendication 10 :
la plaquette de manipulation comportant une couche riche en piège.

12. Structure semi-conductrice selon la revendication 8, comprenant en outre :
une plaquette de manipulation liée à une surface de la plaquette de SOI, la surface de la plaquette de SOI étant à l'opposé de la couche d'isolant par rapport à la couche de substrat, la plaquette de manipulation ayant une couche de substrat de manipulation ; et
une troisième couche active formée dans et sur la couche de substrat de manipulation.

13. Structure semi-conductrice selon la revendication 12 :
la troisième couche active étant formée dans et sur une partie restante de la couche de substrat de manipulation après que la couche de substrat de manipulation a été amincie.
